# EUROPÄISCHE PATENTSCHRIFT

(11) **EP 0 759 221 B1**
(45) Veröffentlichungstag und Bekanntmachung des Hinweises auf die Patenterteilung: **22.10.1997**
(21) Anmeldenummer: 95920806.7
(22) Anmeldetag: 09.05.1995
(51) Int. Cl.: H02H 7/26, G01R 31/08

(54) **SCHALTUNGSANORDNUNG ZUR ERMITTLUNG EINES ERDSCHLUSSES IN EINEM ENERGIEÜBERTRAGUNGSKABEL**
CIRCUITRY FOR DETECTING EARTH LEAKAGES IN ENERGY TRANSMISSION CABLES
CIRCUITS DE DETECTION DE PERTES A LA TERRE DANS DES CABLES DE TRANSMISSION D'ENERGIE

(30) Priorität: 13.05.1994 DE 4416966
(43) Veröffentlichungstag der Anmeldung: 26.02.1997
(73) Patentinhaber: KARL PFISTERER ELEKTROTECHNISCHE SPEZIALARTIKEL GMBH & CO. KG, 70327 Stuttgart (DE)
(72) Erfinder: SANDER, Dieter, D-70619 Stuttgart (DE); FISCHER, Gottfried, D-70599 Stuttgart (DE); BECHTEL, Manfred, D-34127 Kassel (DE)
(74) Vertreter: Patentanwälte Bartels und Partner
(86) Internationale Anmeldenummer: EP9501744
(87) Internationale Veröffentlichungsnummer: WO9531846

(56) Entgegenhaltungen:
- DE-A- 3 627 479
- PATENT ABSTRACTS OF JAPAN, vol. 013, no. 333 (E-794), 26. Juli 1989 & JP-A-01 097129 (TOSHIBA CORP), 14. April 1989
- PATENT ABSTRACTS OF JAPAN, vol. 016, no. 097 (E-1176), 10. März 1992 & JP-A-03 277116 (TAKAOKA ELECTRIC MFG CO LTD), 9. Dezember 1991

## Beschreibung

Die Erfindung betrifft eine zur Ermittlung eines Erdschlusses in einem Energieübertragungskabel vorgesehene Schaltungsanordnung, die die Merkmale des Oberbegriffs des Anspruches 1 aufweist.

Wenn in einem Kabelnetz, insbesondere einem Kabelnetz mit einer Mehrzahl sogenannter Ortsnetztransformatorstationen, ein Erdschluß auftritt, ist das Auffinden desjenigen Abschnittes des Kabelnetzes, in dem der Erdschluß aufgetreten ist, häufig zeitraubend, weil dazu in der Regel nacheinander alle innerhalb des Netzes liegenden Transformatorstationen angefahren werden müssen, um von dort aus den Erdschluß lokalisieren und dann den mit dem Erdschluß behafteten Abschnitt des Kabels abschalten zu können. Eine rasche Lokalisierung des Erdschlusses ist nicht nur aus Gründen der Aufrechterhaltung der Energieversorgung wichtig, sondern auch im Hinblick darauf, daß ein zunächst nur einphasiger Erdschluß dann, wenn er längere Zeit bestehen bleibt, einen mehrphasigen Erdschluß verursachen kann.

Eine Schaltungsanordnung der eingangs genannten Art ist bereits aus der japanischen Veröffertlichung JP1097129 bekannt. Diese Anordnung ermöglicht die Ermittlung eines Erdschlusses in einem Kabelabschnitt und dessen selbsttätige Abschaltung, nicht jedoch die Lokalisierung des Erdschlusses.

Der Erfindung liegt daher die Aufgabe zugrunde, eine Schaltungsanordnung der eingangs genannten Art zu schaffen, mittels deren kurzfristig der Erdschluß lokalisiert werden kann. Diese Aufgabe löst eine Schaltungsanordnung mit den Merkmalen des Anspruches 1.

Die Detektoreinrichtung kann wie dies auch bei der genannten japanischen Veröffentlichung der Fall ist, so ausgebildet sein, daß sie unmittelbar auf einen Erdschlußstrom anspricht, wenn dieser von der Seele der mit dem Erdschluß behafteten Ader über deren Abschirmung zu den beiden Kabelenden fließt, wo die Abschirmung geerdet ist. Die Erfassung des über die Abschirmung fließenden Stromes ist in verschiedener Weise möglich. Man kann beispielsweise zwischen die Abschirmung und die Erdungsstelle einen Stromwandler einfügen. Es genügt aber auch ein Widerstand, an dem der Erdschlußstrom einen Spannungsabfall erzeugt. Besonders vorteilhaft ist die Anordnung einer Spule zwischen der Abschirmung und dem Erdungspunkt. Mit einer solchen Spule, an welcher der vom Erdschlußstrom hervorgerufene Spannungsabfall abgegriffen werden kann, kann nämlich der über die Abschirmung fließende Strom verlustarm wesentlich reduziert werden. Außerdem kann die Spule zusammen mit der Kapazität des Kabels einen Schwingkreis bilden, auf dessen Spannung Signale zur Datenübertragung über die Abschirmung aufmoduliert werden können. In diesem Falle bildet also die Detektoreinrichtung einen Teil des erfindungsgemäß vorgesehenen Systems, mit dem über die Abschirmung Daten übertragen werden können. Selbstverständlich ist eine Datenübertragung auch dann möglich, wenn für die Detektoreinrichtung Stromwandler vorgesehen sind.

Da die Detektoreinrichtung erfindungsgemäß Teil eines Datenübertragungssystems ist, kann man einen Erdschluß mittelbar lokalisieren, wenn die Abschirmung derjenigen Kabelader, die mit dem Erdschluß behaftet ist, nicht mehr in der Lage ist, Daten zu übertragen. Sind alle Ortsnetztransformatorstationen mit einer Datensendeeinrichtung ausgerüstet, welche ständig bestimmte Daten an eine Zentrale über die Kabelabschirmung und insbesondere über die Abschirmungen der einzelnen Adern sendet, kann von der Zentrale aus sofort erkannt werden, zwischen welchen Stationen der Erdschluß aufgetreten ist, da Daten nur noch von den vor der Erdschlußstelle liegenden Stationen ankommen, nicht aber mehr von den hinter der Erdschlußstelle liegenden Stationen. Steht eine derartige ständige Datenübertragung nicht zur Verfügung, kann man den Erdschluß auch dann von der Zentrale aus lokalisieren, wenn die einzelnen Stationen mit einer von der Zentrale aus aktivierbaren Sendeeinrichtung ausgerüstet sind. Es braucht dann nur überprüft zu werden, welche Station noch erreicht werden kann und auf einen Aktivierungsbefehl antwortet und welche Station nicht mehr erreichbar ist.

Wenn, was vorzugsweise der Fall ist, jeder Kabelabschnitt an den beiden mit je einer Station verbundenen Enden eine erfindungsgemäße Detektoreinrichtung aufweist, mit der die Stärke des über die Abschirmung fließenden Erdschlußstromes gemessen werden kann, kann aufgrund der beiden Stromanteile, die von der Erdschlußstelle zum einen bzw. anderen Kabelende fließen, festgestellt werden, in welcher Entfernung der Erdschluß von der einen und/oder anderen Station eingetreten ist. Hierdurch wird eine Beseitigung des Erdschlusses wesentlich erleichtert.

Bei mehradrigen Kabeln, deren Adern je eine Abschirmung aufweisen, ist zweckmäßigerweise jeder Aderabschirmung an beiden Enden des Kabelabschnittes eine Detektoreinrichtung zugeordnet. Zum einen kann dann jeder einphasige Erdschluß erkannt werden. Zum anderen können die Abschirmungen der unbeschädigten Adern weiterhin zur Datenübertragung genutzt werden.

Im folgenden ist die Erfindung anhand von zwei in der Zeichnung dargestellten Ausführungsbeispielen im einzelnen erläutert.

Es zeigen
- Fig. 1: eine schematische Darstellung eines von einer Zentrale ausgehenden Kabelnetzes mit mehreren Ortsnetztransformatorstationen,
- Fig. 2: eine Ortsnetztransformatorstation mit zwei an sie angeschlossenen, mehradrigen Kabeln und den diesen zugeordneten Detektoreinrichtungen mit zugehöriger Elektronik,
- Fig. 3: ein mit einem einphasigen Erdschluß behaftetes Kabel und den beiden am Kabelende vorgesehenen Detektoreinrichtungen,
- Fig. 4: eine Ortsnetztransformatorstation mit zwei an sie angeschlossenen Kabeln und den Detektoreinrichtungen eines zweiten Ausführungsbeispiels mit der zugehörigen Elektronik.

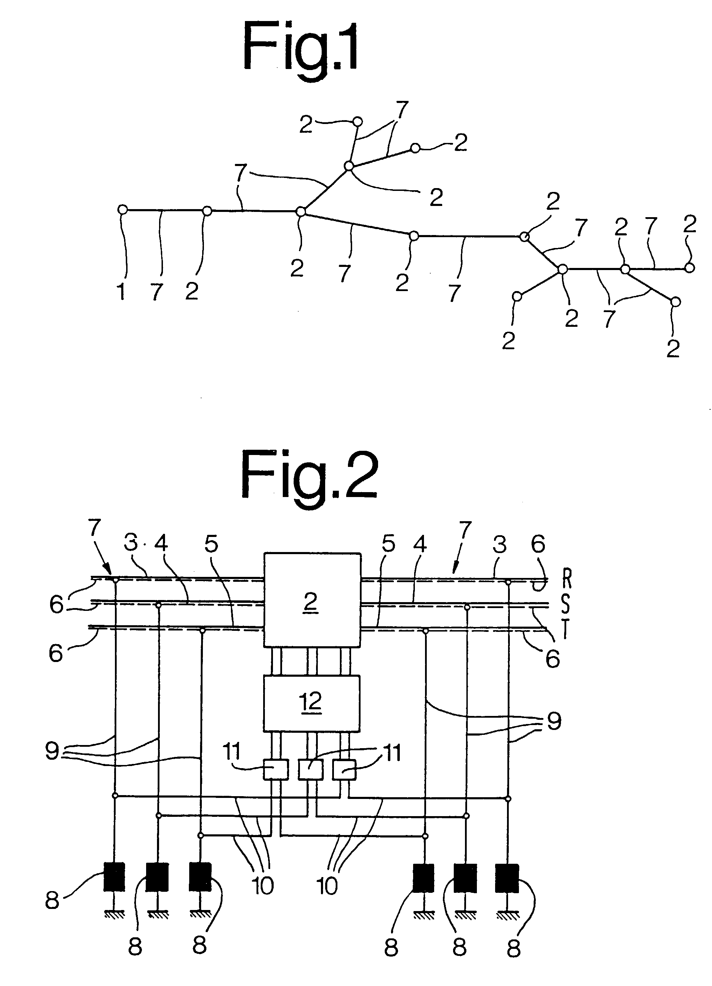

Ein Mittelspannungsenergieversorgungsnetz mit einer Betriebsspannung von beispielsweise 24kV, das von einer Zentrale 1 ausgehend sich mehrmals verzweigt, weist, wie Fig. 1 zeigt, im Ausführungsbeispiel nicht nur an den Verzweigungsstellen, sondern auch in den zu letzteren führenden Abschnitten sogenannte Ortsnetztransformatorstationen 2 auf. Selbstverständlich könnten an die Zentrale 1 noch andere Netzteile angeschlossen sein.

Wie Fig. 2 für eine der Ortsnetztransformatorstationen 2 zeigt, weisen die Kabel je drei Adern 3, 4 und 5 auf, die je von einer Abschirmung 6 umgeben und den drei Phasen R, S bzw. T des Netzes zugeordnet sind. Der die Zentrale 1 mit der dieser am nächsten liegenden Ortsnetztransformatorstation 2 verbindende Kabelabschnitt ist ebenso wie jeder der sich von einer Ortsnetztransformatorstation 2 zur nächsten Ortsnetztransformatorstation 2 erstreckende Kabelabschnitt mit 7 gekennzeichnet.

Die Abschirmungen 6 der drei Adern 3, 4 und 5 jedes Abschnittes 7 sind in dem mit einer der Ortsnetztransformatorstationen 2 oder der Zentrale 1 verbundenen Endbereich über je eine Spule 8 geerdet. Alle Spulen 8 haben die gleiche Dimensionierung. An jede der Verbindungsleitungen 9, welche die Spulen 8 mit der zugeordneten Abschirmung 6 verbinden, ist eine Spannungsabgriffsleitung 10 angeschlossen, die zu einem Übertrager 11 führt. Im Ausführungsbeispiel sind jeweils diejenigen beiden Übertragungsleitungen 11, die mit den Abschirmungen 6 der derselben Phase zugeordneten Adern verbunden sind, an einen gemeinsamen Übertrager angeschlossen. Die Übertrager 11 enthalten je eine für eine Datenübertragung erforderliche Elektronik.

Im Endbereich des an die Zentrale 1 angeschlossenen Abschnittes 7 führt nur jeweils eine Verindungsleitung 9 zu den drei Übertragern, wohingegen dort, wo mehr als zwei der Abschnitte 7 miteinander verbunden sind, entweder mehr als zwei Verbindungsleitungen zu jedem Übertrager 11 führen oder mehr als drei Übertrager vorzusehen sind.

Alle der im Bereich einer der Ortsnetztransformatorstationen 2 vorhandenen Übertrager 11 sind an eine Datenverarbeitungs- und Steuerungselektronik 12 angeschlossen. Entsprechendes gilt für diejenigen Übertrager, welche dem an die Zentrale 1 angeschlossenen Endabschnitt zugeordnet sind.

Wie Fig. 2 zeigt, ist die Datenverarbeitungs- und Steuerelektronik 12 an die zugehörige Ortsnetztransformatorstation 2 angeschlossen, weil sie auch der Weiterleitung von Daten aus der Ortsnetztransformatorstation 2, beispielsweise von Informationen über Strom, Spannung, Leistung und Schalterzustand, dient. Wenn es nur um die Ermittlung eines Erdschlusses in einer der Adern 3, 4 oder 5 geht, ist allenfalls eine Verbindung zwischen der Datenverarbeitungs- und Steuerelektronik 12 mit der Ortsnetztransformatorstation 2 zum Zwecke einer Energieversorgung erforderlich.

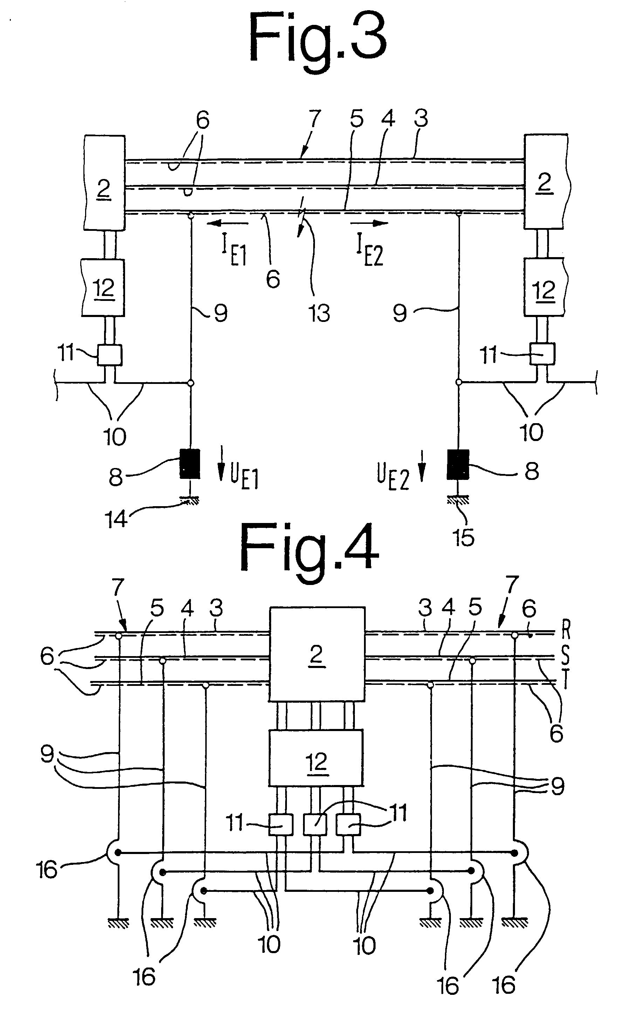

Wenn, wie in Fig. 3 durch einen Pfeil 13 dargestellt, in der Ader 5 des sich zwischen zwei benachbarten Ortsnetztransformatorstationen 2 erstreckenden Abschnittes 7 ein Erdschluß auftritt, fließt ein erster Erdschlußteilstrom I_{E1} über die Abschirmung 6 dieser Ader 5 zu der in Fig. 3 links dargestellten Anschlußstelle der Verbindungsleitung 9 sowie über die an diese Verbindungsleitung 9 angeschlossene Spule 8 zu deren Erdungsstelle 14. Ein zweiter Erdschlußteilstrom I_{E2} fließt über die Abschirmung 6 in der entgegengsetzten Richtung, bei einer Blickrichtung gemäß Fig. 3 also nach rechts, zu der dort vorhandenen Verbindungsstelle zwischen der Abschirmung 6 und der Erdungsleitung 9, über die dort vorgesehene Spule 8, über die er dann zu deren Erdungsstelle 15 fließt. Wenn, wie im Ausführungsbeispiel, die in Fig. 3 links dargestellte Ortsnetztransformatorstation 2 der Zentrale 1 näher ist als die rechts dargestellte Ortsnetztransformatorstation 2, dann kann, unbeeinträchtigt von dem Erdschluß, die an der in Fig. 3 links dargestellten Spule 8 abgegriffene Spannung U_{E1}, welche der über diese Spule fließende Erdschlußteilstrom erzeugt, in Form eines elektrischen Signales an die Zentrale 1 übertragen werden.

Sofern nicht alle drei Adern einen Erdschluß aufweisen, kann auch von der in Fig. 3 rechts dargestellten Ortsnetztransformatorstation 2 aus der Erdschluß an die Zentrale 1 gemeldet werden. Die an der in Fig. 3 rechts dargestellten Spule 8 durch den über sie fließenden Erdschlußteilstrom I_{E2} hervorgerufene Spannung U_{E2} kann nämlich von der zugehörigen Datenverarbeitungs- und Steuerelektronik 12 als ein entsprechendes Signal über die Abschirmung 6 einer der nicht vom Erdschluß betroffenen Adern zur Zentrale 1 übertragen werden. Eine derartige zweifache Meldung eines Erdschlusses ist deshalb vorteilhafter als allein die von der in Fig. 3 links dargestellten Station aus übertragenen Meldung, weil letztere nur Auskunft darüer geben kann, welcher Abschnitt 7 des Netzes und welche Ader innerhalb dieses Abschnittes von dem Erdschluß betroffen sind. Wenn hingegen außer dem der Spannung U_{E1} entsprechenden Signal auch das der Spannung U_{E2} entsprechende Signal an die Zentrale übertragen werden, kann man, weil der Erdschlußstrom sich entsprechend den Widerstandswerten der Abschirmung zwischen der Erdschlußstelle und den geerdeten Enden des Abschnittes 7 aufteilt, aus der Größe der an den beiden Spulen 8 abfallenden Spannungen U_{E1} und U_{E2} ermitteln, in welcher Entfernung sich die Erdschlußstelle von den beiden Ortsnetztransformatorstationen 2 befindet, zwischen denen der Abschnitt 7 des Kabels verläuft.

Sofern von den Ortsnetztransformatorstationen 2 zur Zentrale 1 ständig oder auf Abruf Daten übertragen werden sollen, wird hierfür von jeder Datenverarbeitungs- und Steuerelektronik 12 eine Trägerfrequenz zur Verfügung gestellt, die wenigstens annähernd gleich der Resonanzfrequenz des Schwingkreises ist, der aus den beiden am Anfang und Ende eines Abschnittes 7 vorgesehenen Spulen 8 und der zugehörigen Ader des Kabels und der Kapazität des Schirmes gebildet ist. Auf diese Trägerfrequenz werden die zu übertragenden Daten von der Datenverarbeitungsund Steuerelektronik 12 aufmoduliert und in der Zentrale 1 demoduliert. Auch hierbei kann natürlich die Datenverarbeitungs- und Steuerelektronik 12 im Falle einer Unterbrechung der Datenleitung durch einen Erdschluß einer der Adern die Datenübertragung über die Abschirmung einer nicht gestörten Ader veranlassen.

Wie Fig. 4 zeigt, kann man statt der Spulen 8 Stromwandler 16 vorsehen. Es kann sich bei diesen Stromwandlern 16 um je einen Ringkern handeln, der eine Spule trägt. Diese Spulen, welche die Sekundärseite der Stromwandler 16 bilden, sind an je einen der Übertrager 11 angeschlossen, die ihrerseits wie bei dem Ausführungsbeispiel gemäß den Fig. 1 bis 3 an eine Datenverarbeitungs- und Steuerelektronik 12 angeschlossen sind.

Die Arbeitsweise des Ausführungsbeispiels gemäß Fig. 4 ist prinzipiell die gleiche wie diejenige des Ausführungsbeispiels gemäß den Fig. 1 bis 3, weshalb wegen weiterer Einzelheiten auf die Ausführungen zu letzterem Bezug genommen wird. Selbstverständlich können auch mit dem Ausführungsbeispiel gemäß Fig. 4 Daten von den einzelnen Ortsnetztransformatorstationen 2 zur Zentrale und in umgekehrter Richtung übertragen werden.

## Patentansprüche

1. Schaltungsanordnung zur Ermittlung eines Erdschlusses in einem Energieübertragungskabel (7) mit einer Abschirmung (6), insbesondere einem einen Abschnitt eines Energieversorgungsnetzes bildenden Kabel, und je einer an jedem der beiden Kabelenden angeschlossenen Detektoreinrichtung (8, 11, 12; 16, 11, 12), welche auf einen über die Abschirmung (6) fließenden Strom (I_{E1}, I_{E2}) anspricht, dadurch gekennzeichnet, daß die Detektoreinrichtung (8, 11, 12; 16, 11, 12) Teil eines Sende- und/oder Empfangsgerätes für über die Abschirmung (6) zu übertragende bzw. übertragene Daten ist.

2. Schaltungsanordnung nach Anspruch 1, dadurch gekennzeichnet, daß bei einem mehradrigen Kabel, dessen Adern (3,4,5) je eine Abschirmung (6) aufweisen, an die Abschirmung (6) jeder Ader (3,4,5) im Bereich der beiden Kabelenden je eine der Detektoreinrichtungen (8,11,12;16,11,12) angeschlossen ist.

3. Schaltungsanordnung nach Anspruch 1 oder 2, dadurch gekennzeichnet, daß die Detektoreinrichtung (16,11,12) einen Ringkern mit einer von ihm durchdrungenen Übertragungsspule aufweist, der die Abschirmung oder wenigstens eine von der Abschirmung (6) zu einem Erdungspunkt geführte Verbindungsleitung (9) umfaßt.

4. Schaltungsanordnung nach Anspruch 1 oder 2, dadurch gekennzeichnet, daß die Detektoreinrichtung (8,11,12) eine Spule (8) aufweist, die zwischen der Abschirmung (6) und einen Erdungspunkt (14) geschaltet ist.

## Claims

1. Circuit arrangement for detecting an earth leak in an energy transmission cable (7) having a shield (6), especially a cable forming a portion of an energy supply network, and a respective detector device (8, 11, 12; 16, 11, 12) which is connected to each of the two cable ends and which responds to a current (I_{E1}, I_{E2}) flowing via the shield (6), characterised in that the detector device (8, 11, 12; 16, 11, 12) is part of a transmitting and/or receiving apparatus for data that are to be transmitted or have been transmitted via the shield (6).

2. Circuit arrangement according to Claim 1,
characterised in that, in the case of a multiconductor cable, of which each of the conductors (3, 4, 5) has a shield (6), a respective one of the detector devices (8, 11, 12; 16, 11, 12) is connected to the shield (6) of each conductor (3, 4, 5) in the region of the two cable ends.

3. Circuit arrangement according to Claim 1 or 2,
characterised in that the detector device (16, 11, 12) has a toroidal core which has a transmission coil through which it penetrates and which toroidal core includes the shield or at least a connecting line (9) guided from the shield (6) to an earthing point.

4. Circuit arrangement according to Claim 1 or 2,
characterised in that the detector device (8, 11, 12) has a coil (8) which is connected between the shield (6) and an earthing point (14).

## Revendications

1. Montage pour déterminer un défaut à la terre dans un câble de transmission d'énergie (7) comportant un blindage (6), notamment un câble constituant un tronçon d'un réseau d'alimentation en énergie, et comportant un dispositif de détection (8, 11, 12 ; 16, 11, 12), qui est raccordé à chacune des extrémités du câble et qui répond à un courant (I_{E1}, R_{E2}), qui circule par l'intermédiaire du blindage (6), caractérisé en ce que le dispositif de détection (8, 11, 12 ; 16, 11, 12) fait partie d'un appareil d'émission et/ou de réception pour des données transmises ou devant être transmises par l'intermédiaire du blindage (6),

2. Montage selon la revendication 1, caractérisé en ce que dans un câble à plusieurs conducteurs, ses conducteurs (3, 4, 5) comportent chacun un blindage (6), et que respectivement l'un des dispositifs de détection (8, 11, 12 ; 16, 11, 12) est connecté au blindage (6) de chaque conducteur (3, 4, 5) au niveau des deux extrémités du câble.

3. Montage selon la revendication 1 ou 2, caractérisé en ce que le dispositif de détection (16, 11, 12) possède un noyau annulaire comportant une bobine de transmission qui est traversée par le noyau annulaire et entoure le blindage ou au moins un conducteur de liaison (9) qui s'étend du blindage (6) jusqu'à un point de mise à la terre.

4. Montage selon la revendication 1 ou 2, caractérisé en ce que le dispositif de détection (8, 11, 12) comporte une bobine (8), qui est branchée entre le blindage (6) et un point de mise à la terre (14).
